# EUROPÄISCHE PATENTSCHRIFT

(11) **EP 2 916 631 B1**
(45) Veröffentlichungstag und Bekanntmachung des Hinweises auf die Patenterteilung: **05.05.2021**
(21) Anmeldenummer: 15157591.7
(22) Anmeldetag: 04.03.2015
(51) Int. Cl.: H05K 3/34, H05K 3/30, H05K 3/28

(54) **STRUKTURIERUNG DER LÖTSTOPPMASKE VON LEITERPLATTEN ZUR VERBESSERUNG DER LÖTERGEBNISSE**
STRUCTURING OF THE SOLDER RESIST MASK OF CIRCUIT BOARDS FOR IMPROVING SOLDERING RESULTS
STRUCTURATION DE VERNIS-ÉPARGNE DE CARTES DE CIRCUIT IMPRIMÉ DESTINÉE À AMÉLIORER LES RÉSULTATS DE SOUDURE

(30) Priorität: 07.03.2014 AT 501702014
(43) Veröffentlichungstag der Anmeldung: 09.09.2015
(73) Patentinhaber: ZKW Group GmbH, 3250 Wieselburg (AT)
(72) Erfinder: Kieslinger, Dietmar, 2604 Theresienfeld (AT)
(74) Vertreter: Patentanwaltskanzlei Matschnig & Forsthuber OG

(56) Entgegenhaltungen:
- EP-A1- 0 996 317
- JP-A- 2012 089 742
- US-A- 4 164 778
- US-A1- 2009 056 985

## Beschreibung

Die Erfindung betrifft ein Verfahren zum lötenden Verbinden zumindest eines elektronischen Bauteils mit zumindest einer Trägerplatte.

Das Anbringen von elektronischen Bauteilen an Trägerplatten, beispielsweise an Printplatten, ist ein sehr häufig erforderlicher Vorgang bei der Herstellung von elektrischen Schaltkreisen. Printplatten weisen dabei im Allgemeinen Leiterbahnen auf, die einzelne oder mehrere Anschlusskontakte miteinander verbinden, wobei einzelne elektronische Bauteile mit den elektrischen Anschlusskontakten verbunden werden. Die Verbindung kann mehrere Aspekte wie beispielsweise eine elektrische, mechanische und/oder thermische Verbindung erfüllen.

Aus dem Stand der Technik sind unterschiedliche Methoden bekannt geworden, mit Hilfe derer eine Verbindung eines elektronischen Bauteils mit einer Trägerplatte realisiert werden kann. So können beispielsweise Kontaktflächen einzelner elektronischer Bauteile, folgend auch als Bauteilkontaktflächen bezeichnet, mit an den Trägerplatten angeordneten Kontaktflächen (folgend auch als Trägerplattenkontaktflächen bezeichnet) verlötet werden.

Aus Dokumenten JP 2012 089748 A und US 4164778 A sind Verfahren zum lötenden Verbinden von elektronischen Bauteilen mit einer Trägerplatte bekannt geworden. Dokument EP 0 996 317 A1 betrifft ebenso ein Verfahren zum lötenden Verbinden und gibt Hinweise auf den Einfluss der Oberflächenspannung eines geschmolzenen Lotes auf die Ausbildung der Lötverbindung. Dokument US 2009/0056985 A1 betrifft ein Verfahren zu Herstellung einer elektrischen Vorrichtung, wobei dabei Lötverbindungen überdruckt werden können. Dokument US 5 085 364 A betrifft ebenso ein lötendes Verbinden von Bauteilen, wobei dabei auf die Möglichkeit der Verwendung eines Klebers hingewiesen wird.

An dieser Stelle sei auf das SMT-Verfahren (Surface Mount Technology) verwiesen, bei welchem sich die elektrischen Anschlüsse bzw. Kontaktflächen des elektronischen Bauteils sowie die korrespondierenden Kontaktflächen der Trägerplatte jeweils an deren Oberfläche befinden und die elektronischen Bauteile lediglich an der Oberfläche der Trägerplatte befestigt werden müssen und auf das Vorsehen von Durchgangsbohrungen verzichtet werden kann. Die Kontaktflächen der Trägerplatte werden hierbei zuerst mit einem Lötmittel, zumeist einer Lötpaste, beschichtet. Im Anschluss erfolgt die Bestückung der Trägerplatte mit einzelnen elektronischen Bauteilen.

Zur Herstellung einer dauerhaften elektrischen und/oder thermischen und/oder mechanischen Verbindung der elektronischen Bauteile mit der Trägerplatte ist beispielsweise das Reflow-Lötverfahren bekannt geworden (welches bei der gegenständlichen Erfindung angewandt werden kann), bei welchem die Lötpaste und die Kontaktflächen nach der Bestückung mit den elektronischen Bauteilen dergestalt erhitzt werden, dass die Lötpaste schmilzt und sich mit den Kontaktflächen der Trägerplatte sowie des jeweiligen elektronischen Bauteils verbindet.

Im klassischen SMT- Prozess enthält eine Lötpaste sowohl ein Lötgut (welches nach dem beteiligte Kontaktflächen dauerhaft verbindet) als auch Flussmittel, die die Lötbarkeit (insbesondere das Fluss- und Benetzungsverhalten) des Lötguts verbessern. Die Lötpaste wird zumeist in einem Sieb- bzw. Masken-Druckprozess in Form von Lötdepots auf eine Trägerplatte aufgebracht, bevor elektronische Bauteile darauf platziert werden. Die Formen der Lotdepots folgen dabei im Allgemeinen der Form korrespondierender Trägerplattenkontaktflächen, sodass die Paste lediglich auf die Trägerplattenkontaktflächen aufgebracht wird. Fläche und Höhe (bzw. Dicke) des Lötdepots legen das Volumen des Lötdepots und somit die aufgebrachte Menge an Lötpaste fest. Um die Menge an Lötpaste an einem Lötdepot an unterschiedliche Anforderungen anpassen zu können - die z.B. durch das Gewicht oder die mechanische Beanspruchung einzelner elektronischer Bauteile bedingt sein können - sind aus dem Stand der Technik Sieb- bzw. Masken-Druckprozesse bekannt geworden, die unterschiedliche Höhen bzw. Dicken der Lötdepots ermöglichen, wodurch jeweilige Kontaktflächen mit speziell angepassten Mengen an Lötgut benetzt werden können. Dergestalt optimierte Sieb- bzw. Masken-Druckprozesse sind äußerst kostenintensiv.

Es ist daher eine Aufgabe der Erfindung eine alternative Möglichkeit zur gezielten Anpassung der Lötmenge an Kontaktflächen zu schaffen, um eine verbesserte Verbindung von Kontaktflächen elektronischer Bauteile an Kontaktflächen von Trägerplatten zu ermöglichen.

Diese Aufgabe wird mit einem Verfahren nach Anspruch 1 gelöst. Dies ist bei der Verwendung von elektronischen Bauteilen ohne hervorstehende Anschlüsse, sogenannten leads (solche Bauteile werden dann als leadless bezeichnet), von Vorteil, die vom Einsatz von Hilfskontaktflächen besonders profitieren. Die elektronischen Bauteile weisen als elektronische Bauteile ohne leads ein QFN- Gehäuse (quad-flat no-leads) auf. Mit Hilfe der erfindungsgemäßen Merkmale ist es möglich, die Lötmenge an einer Kontaktfläche zu erhöhen, indem Lötpaste über die jeweilige Trägerplattenkontaktfläche hinaus auf die Lötstopplackschicht aufgetragen wird. Die Hilfskontaktfläche ermöglicht es auf der Lötstopplackschicht aufgebrachtes geschmolzenes Lötgut einzufangen und an die Trägerplattenkontaktfläche heranzuführen. Dieser Effekt ist auf die Oberflächenspannung des geschmolzenen Lötguts zurück zu führen, wodurch Kräfte wirken, die auf der Lötstopplackschicht befindliches geschmolzenes Lötgut, welches sich in der Umgebung der Hilfskontaktfläche befindet, an die Hilfskontaktfläche und somit an die benachbarte Trägerplattenkontaktfläche heranziehen. Dieser Effekt ist bei elektronischen Bauteilen, die die Trägerplattenkontaktfläche vollständig überdecken von besonderem Vorteil sein, da eine Überprüfung der Lötverbindung (welche aufgrund der Überdeckung nur erschwert möglich wäre) aufgrund der zuverlässigen Zufuhr von ausreichenden Mengen an Lötgut entfallen kann. Die Lötmenge an einer Kontaktfläche kann durch sogenanntes "Überdrucken" - also ein Aufbringen von Lötpaste über die jeweilige Kontaktfläche hinaus auf eine die Kontaktfläche umgebende Lötstopplackschicht - der jeweiligen Kontaktfläche gezielt beeinflusst werden, wobei das Ausmaß des zusätzlichen überdruckten "Nichtkontaktflächenbereiches" den zusätzlichen Zustrom an Lötgut an die jeweilige Kontaktfläche wesentlich beeinflusst. Anders ausgedrückt, kann die Lötmenge durch deutliche Erhöhung der bedruckbaren Fläche gezielt beeinflusst werden. Hierfür ist das Vorhandensein der Hilfskontaktfläche wesentlich, da anderenfalls nur geringe Mengen an Lötgut an die Kontaktflächen herangeführt werden können und zudem lose Lötgutrückstände an der Lackstoppschicht verbleiben können, die unter Umständen Kurzschlüsse verursachen können. Zudem kann die Hilfskontaktfläche dazu herangezogen werden, um auf die Temperatur eines mit der Trägerplattenkontaktfläche verbundenen elektronischen Bauteils rückzuschließen. Dabei kann es sich beispielsweise um die Sperrschichttemperatur einer LED handeln.

Unter dem Ausdruck "kanalartige Aussparung" wird dabei eine Aussparung im Lötstopplack verstanden, die einen funktionellen Kanal bildet, um Lötgut im geschmolzenen Zustand an die Trägerplattenkontaktfläche heran zu führen. Auf besonders geeignete geometrische Formen wird im Folgenden noch näher eingegangen. Die Breite eines solchen Kanals beträgt vorzugsweise mindestens 80 µm. Es versteht sich natürlich selbst, dass die Erfindung ebenso für mehrere Trägerplattenkontaktflächen eingesetzt werden kann, die einem oder mehreren elektronischen Bauteilen zugeordnet sein können. Eine benetzbare Oberfläche im Sinne der Erfindung ist eine Oberfläche, die von Lötgut (bzw. Lötmittel) benetzt werden kann, sodass bei einem Abkühlen des Lötguts eine feste Verbindung zwischen der Oberfläche und dem Lötgut hergestellt werden kann.

In einer bevorzugten Ausführungsform der Erfindung kann es vorgesehen sein, dass die Hilfskontaktfläche die Trägerplattenkontaktfläche entlang von maximal 5%, 10%, 15% oder 20% des Umfangs der Trägerplattenkontaktfläche kontaktiert. Die Wirkung der Hilfskontaktfläche als Zubringer von zusätzlichem Lötgut kann damit besonders effektiv entfaltet werden. Insbesondere kann es vorgesehen sein, dass der Flächeninhalt der Hilfskontaktfläche zwischen 10% und 50%, vorzugsweise zwischen 30% und 50% des Flächeninhalts der Trägerplattenplattenkontaktfläche beträgt.

In einer besonders günstigen Weiterbildung der Erfindung ist die Hilfskontaktfläche im Wesentlichen dreieckig, vorzugsweise als gleichschenkeliges Dreieck geformt. Alternativ dazu kann die Hilfskontaktfläche im Wesentlichen rechteckig geformt sein. Unter dem Ausdruck "im Wesentlichen" ist in diesem Zusammenhang eine Form zu verstehen, die im Wesentlichen als solche erkennbar ist. So ist beispielsweise eine rechteckige Fläche mit abgerundeten Ecken weiterhin als eine im Wesentlichen rechteckige Fläche im Sinne der Erfindung anzusehen. Auch halbkreis- oder bogenförmige Aussparungen sind denkbar.

In einer günstigen Weiterbildung der Erfindung weist die Hilfskontaktfläche einen symmetrischen Aufbau um eine Symmetrieachse auf, wobei die Symmetrieachse im Wesentlichen normal zu jenem Bereich des Umfangs der Trägerplattenkontaktfläche orientiert ist, in welchem die Hilfskontaktfläche die Trägerplattenkontaktfläche kontaktiert. Die Hilfskontaktfläche ragt somit besonders weit in den die Trägerplattenkontaktfläche umgebenden Bereich hinein, der mit Lötstopplack beschichtet ist.

In einer bevorzugten Ausführungsform der Erfindung sind die Kontaktflächen (also die Trägerplattenkontaktflächen, die Bauteilkontaktflächen und die Hilfskontaktflächen) Zinn, Silber und/oder Gold beschichtet. Die Zinn-, Silber- und/oder Goldschicht schützt die Kontaktfläche vor Korrosion und kann auf andere elektrisch leitende unterhalb (der schützenden Zinn, Silber und/oder Goldfläche) angeordnete Schichten aufgetragen werden und diese schützend bedecken. Bei Trägerplatten handelt es sich bei diesen unterhalb angeordneten Schichten häufig um Kupferschichten, die auf einem elektrisch isolierenden Trägermaterial angeordnet sind. Bei Bauteilen können unterhalb angeordnete Schichten aus den verschiedensten Materialien wie beispielsweise aus Aluminium, Kupfer, Eisenlegierung, Nickel und/oder diversen Halbleitermaterialen bestehen.

Gemäß einer besonders einfachen und kostengünstigen Variante der Erfindung kann die Trägerplattenkontaktfläche auf einer Zuleitung zur Trägerplattenkontaktfläche ausgebildet sein.

Um die Menge an Lötgut, welches der Trägerplattenkontaktfläche zugeführt werden kann, spezifisch festzulegen bzw. zusätzlich zu erhöhen, kann in einer günstigen Weiterbildung der Erfindung vorgesehen sein, dass eine, vorzugsweise zwei, besonders bevorzugt mehrere weitere Hilfskontaktflächen die Trägerplattenkontaktfläche kontaktieren.

Erfindungsgemäß ist vorgesehen, dass das zumindest eine elektronische Bauteil zusätzliche mittels Klebepunkten an der Trägerplatte fixiert ist, wobei die Härtetemperatur der Klebepunkte (bzw. des Klebers) unterhalb der Schmelztemperatur einer auf die Trägerplattenkontaktfläche aufgebrachten Lötpaste liegt. Dies erlaubt eine besonders positionsstabile Fixierung des elektronischen Bauteils.

Die Erfindung betrifft ein Verfahren zum lötenden Verbinden zumindest eines elektronischen Bauteils mit zumindest einer Trägerplatte nach Anspruch 1.

Die Lötpaste ist dabei dergestalt über die Trägerplattenkontaktfläche hinaus bedruckt (oder ein Lötmittel wird entsprechend zugeführt), sodass die Hilfskontaktfläche geschmolzene Lötpaste "einfangen" und an die Trägerplattenkontaktfläche und somit an die dazu korrespondierende Bauteilkontaktfläche heranführen kann. Typischerweise wird die Lötpaste während des Schmelzvorganges Temperaturen von über 180°C, insbesondere über 183°C (bei bleihaltigen Lötpasten) bzw. über 215°C, insbesondere über 217°C (bei bleifreien Lötpasten) ausgesetzt. Temperaturen von über 250°C sind für einige elektronische Bauteile schädlich, wodurch die maximal erreichbare Temperatur häufig auf 250°C begrenzt ist. Die Lötpaste schmilzt dabei, in der Lötpaste enthaltene Flussmittel verdampfen zumindest teilweise und das auf der Trägerplattenkontaktfläche und in seiner Umgebung befindliche Lötgut (im Rahmen dieser Beschreibung wird unter dem Begriff Lötgut jener Bestandteil der Lötpaste bzw. des Lötmittels verstanden, der elektrisch leitfähig ist und nicht während des Erhitzens verdampft) setzt sich auf der Trägerplattenkontaktfläche fest. Generell können beliebige Lötpasten hierfür eingesetzt werden. Beispielhaft seien bekannte Lötpasten wie SAC305 (eine bleifreie Legierung bestehend aus ca. 96.5% Zinn, 3% Silber und 0,5 % Kupfer) oder niedrig-Silberlegierungen wie z.B. SAC0105 oder Legierungen enthaltend Bismut, Kobalt oder Mangan sein. Lötpasten können sich zudem durch die eingesetzten Flussmittel bzw. deren Zusammensetzung voneinander unterscheiden.

In einer günstigen Weiterbildung des erfindungsgemäßen Verfahrens kann die in Schritt a) auf die zumindest eine Kontaktfläche aufgebrachte Lötpaste eine Fläche der Größe von zumindest 120%, vorzugsweise zumindest 150% des Flächeninhalts der Trägerplattenkontaktfläche bedecken. Die Lötpaste wird daher auf die Trägerplattenkontaktfläche und über diese hinaus auf die Trägerplatte aufgebracht.

Um die Lötgutmenge an der Trägerplattenkontaktfläche zu erhöhen ist vorgesehen, dass in Schritt a) zumindest die gesamte Hilfskontaktfläche mit Lötpaste bedeckt wird. Zudem ist vorgesehen, dass in Schritt a) die Lötpaste über die Hilfskontaktfläche hinaus aufgebracht wird. Dabei weist die über den Hilfskontakt hinaus gehende mit Lötpaste bedeckte Fläche einen Flächeninhalt von zumindest 100%, besonders bevorzugt zumindest 200% des Flächeninhaltes der Hilfskontaktfläche auf.

In einer günstigen Ausführungsform der Erfindung wird die Trägerplattenkontaktfläche von der die Hilfskontaktfläche entlang von maximal 5%, 10%, 15% oder 20% des Umfangs der Trägerplattenkontaktfläche kontaktiert. Der Umfang der Trägerplattenkontaktfläche wird im Allgemeinen durch die die Trägerplattenkontaktfläche umgebende Lötstopplackschicht begrenzt, wobei die Umfangslinie in jenem Bereich, indem die Lötstopplackschicht durch die Hilfskontaktfläche unterbrochen ist, einer Verlängerung der an die Hilfskontaktfläche anschließenden Kanten der Trägerplattenkontaktfläche entspricht.

In einer günstigen Weiterbildung der Erfindung beträgt der Flächeninhalt der Hilfskontaktfläche zwischen 10% und 50%, vorzugsweise zwischen 30% und 50% des Flächeninhalts der Trägerplattenplattenkontaktfläche.

Es ist vorgesehen, dass in Schritt b) die Trägerplattenkontaktfläche vollständig von dem elektronischen Bauteil überdeckt wird. Die Funktion der Hilfskontaktfläche kommt dabei besonders zu tragen.

Des Weiteren kann es vorgesehen sein, dass die Hilfskontaktfläche im Wesentlichen dreieckig, vorzugsweise als gleichschenkeliges Dreieck geformt ist. Alternativ dazu kann die Hilfskontaktfläche beispielsweise im Wesentlichen rechteckig geformt sein.

In einer besonders vorteilhaften Variante der Erfindung kann es vorgesehen sein, dass die Hilfskontaktfläche einen symmetrischen Aufbau um eine Symmetrieachse aufweist, wobei die Symmetrieachse im Wesentlichen normal zu jenem Bereich des Umfangs der Trägerplattenkontaktfläche orientiert ist, in welchem die Hilfskontaktfläche die Trägerplattenkontaktfläche kontaktiert.

Zudem kann es vorgesehen sein, dass die Kontaktflächen mit Zinn, Silber und/oder Gold beschichtet sind.

In einer besonders günstigen Variante des erfindungsgemäßen Verfahrens kann die Trägerplattenkontaktfläche auf einer Zuleitung zur Trägerplattenkontaktfläche ausgebildet sein.

Um die Menge an Lötgut, welches der Trägerplattenkontaktfläche zugeführt werden kann, spezifisch festzulegen bzw. zusätzlich zu erhöhen, kann in einer günstigen Weiterbildung des erfindungsgemäßen Verfahrens vorgesehen sein, dass eine, vorzugsweise zwei, besonders bevorzugt mehrere weitere Hilfskontaktflächen die Trägerplattenkontaktfläche kontaktieren.

Es ist erfindungsgemäß vorgesehen, dass das zumindest eine elektronische Bauteil zusätzliche mittels Klebepunkten an der Trägerplatte fixiert ist. Dies erlaubt eine besonders positionsstabile Fixierung des elektronischen Bauteils.

Dabei ist vorgesehen, dass die Härtetemperatur der Klebepunkte unterhalb der Schmelztemperatur einer auf die Trägerplattenkontaktfläche aufgebrachten Lötpaste liegt, wodurch ein Aushärten des Klebers bzw. der Klebepunkte vor dem Schmelzen der Lötpaste sichergestellt werden kann und ein Verschwimmen des elektronischen Bauteils während des Schmelzvorganges der Lötpaste vorgebeugt werden kann.

Die Erfindung samt weiteren Ausgestaltungen und Vorteilen ist im Folgenden an Hand einer beispielhaften, nicht einschränkenden Ausführungsform näher erläutert, die in den Figuren veranschaulicht ist. Hierbei zeigt
Fig. 1 eine Draufsicht auf eine Trägerplatte mit drei Trägerplattenkontaktflächen und Zuleitungen,
Fig. 2 ein elektronisches Bauteil zur Befestigung an der Trägerplatte,
Fig. 3a eine Draufsicht auf die Trägerplatte der Fig. 1 mit einem daran anzubringenden elektronischen Bauteil,
Fig. 3b eine Schnittdarstellung der Trägerplatte entlang der Schnittlinie AA der Fig. 3a,
Fig. 4a eine Draufsicht auf die Trägerplatte der Fig. 3a mit einem daran befestigten elektronischen Bauteil während eines Schmelzvorganges,
Fig. 4b eine Schnittdarstellung der Trägerplatte entlang der Schnittlinie AA der Fig. 4a,
Fig. 5a eine Draufsicht auf die Trägerplatte der Fig. 4a nach dem Schmelzvorgang,
Fig. 5b eine Schnittdarstellung der Trägerplatte entlang der Schnittlinie AA der Fig. 5a,
Fig. 6a eine Draufsicht auf ein System umfassend eine Trägerplatte und zumindest ein an der Trägerplatte montierten elektronischen Bauteil, das mit einem erfindungsgemäßen Verfahren herstellbar ist,
Fig. 6b eine Schnittdarstellung der Trägerplatte entlang der Schnittlinie AA der Fig. 6a,
Fig. 7a eine Detailansicht einer Trägerplattenkontaktfläche mitsamt einem die Trägerplattenkontaktflächen umgebenden Bereich während eines Schmelzvorganges,
Fig. 7b eine Seitenansicht der der Fig. 7a zugehörigen Trägerplatte während des Schmelzvorganges,
Fig. 8 die Trägerplatte gemäß Fig. 7a nach dem Schmelzvorgang,
Fig. 9a eine Detailansicht einer Hilfskontaktfläche während eines Schmelzvorganges, und
Fig. 9b eine Detailansicht einer Hilfskontaktfläche nach einem Schmelzvorgang.

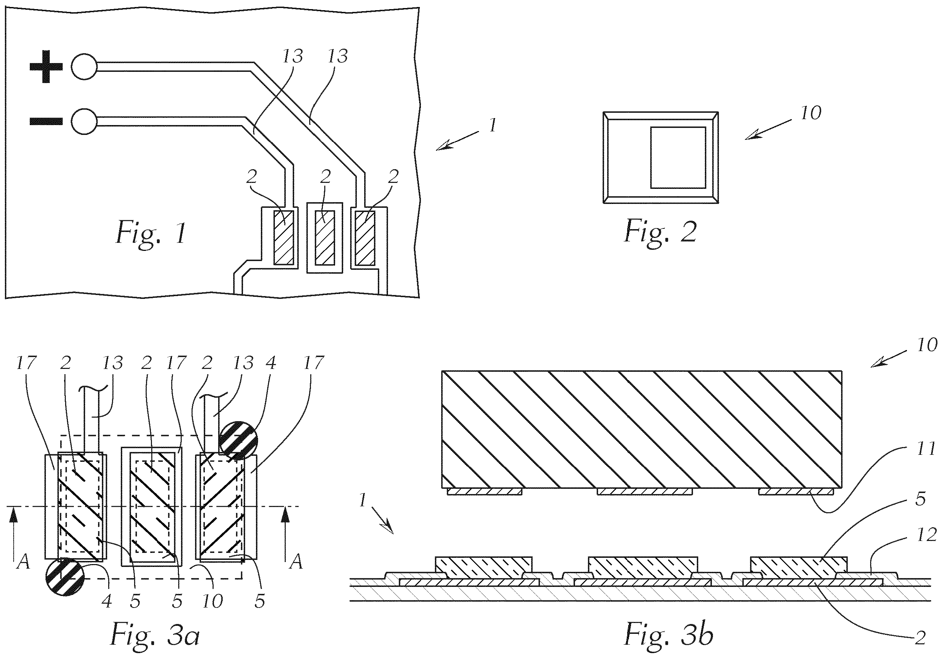

Im Folgenden werden die Nachteile des Standes der Technik in den Figuren 1 bis 5b näher erörtert. In den Figuren werden - sofern nicht anders angegeben - mit gleichen Bezugszeichen gleiche Merkmale beschriftet.

Fig. 1 zeigt eine Draufsicht auf eine Trägerplatte 1, die drei Trägerplattenkontaktflächen 2 und jeweils zwei zu den Trägerplattenkontaktflächen 2 führende Zuleitungen 13 aufweist. Diese Trägerplatte 1 entspricht einer Trägerplatte, wie sie aus dem Stand der Technik bekannt ist.

Fig. 2 zeigt eine Draufsicht auf ein elektronisches Bauteil 10, welches auf der Trägerplatte 1 befestigt werden soll.

Fig. 3a zeigt eine Draufsicht auf einen Ausschnitt der Trägerplatte 1, wobei die Position des das daran anzubringenden elektronischen Bauteils 10 durch eine strichlierte Linie angedeutet ist. Zusätzlich sind Klebepunkte 4 erkennbar, mit Hilfe derer das elektronische Bauteil 10 auf der Trägerplatte 1 befestigt werden soll. Die Trägerplattenkontaktflächen 2 sind großzügig mit Lötpaste 5 bedruckt, sodass diese nahezu vollständig von der Lötpaste 5 bedeckt werden und sich die Lötpaste 5 über die Kontaktfläche 2 hinaus erstreckt. Die Trägerplattenkontaktflächen 2 sind jeweils als Teil einer Kupferfläche 17 (die vorzugsweise mit Silber, Zinn und/oder Gold beschichtet ist) ausgebildet, die in deren Randbereichen mit einer Lötstopplackschicht 12 (siehe Fig. 3b) bedeckt sind. Die Trägerplattenkontaktflächen 2 werden durch die Lötstopplackschicht 12 begrenzt.

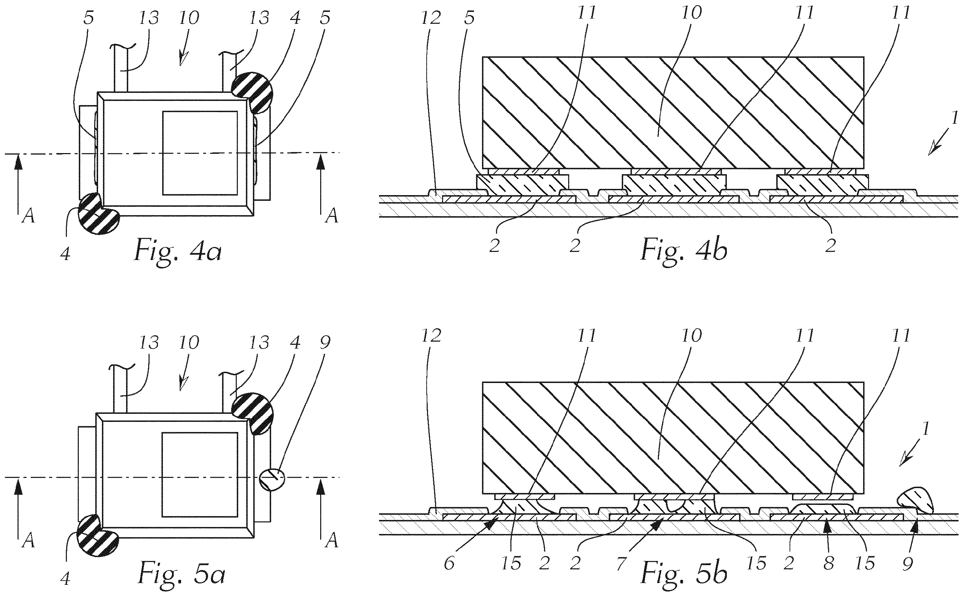

Fig. 3b zeigt eine Schnittdarstellung der Trägerplatte 1 entlang der Schnittlinie AA der Fig. 3a, wobei darin das elektronische Bauteil 10 erkennbar ist, welches oberhalb der Trägerplatte 1 positioniert ist. Das elektronische Bauteil 10 weist Kontaktflächen auf, die im Folgenden als Bauteilkontaktflächen 11 bezeichnet sind, und dazu eingerichtet sind, mittels der Lötpaste 5 bzw. darin enthaltenem Lötgut mit Trägerplattenkontaktflächen 2 verbunden zu werden. Fig. 4a zeigt eine Draufsicht auf die Trägerplatte 1 der Fig. 3a, wobei das elektronische Bauteil 10 bereits an der Trägerplatte 1 angebracht ist. Die Lötpaste 5 wird darin durch das Aufsetzen des elektronischen Bauteils 10 unter Umständen gequetscht, sodass sich eine durchgängige Schicht an Lötpaste 5 bilden kann. Im Beispiel gemäß Fig. 4b, die eine Schnittdarstellung der Trägerplatte 1 entlang der Schnittlinie AA der Fig. 4a zeigt, ist die Verformung der Lötpaste 5, die durch das Bestücken mit dem elektronischen Bauteil 10 verursacht wurde, vernachlässigbar. Ein aus dem Stand der Technik bekanntes Verfahren zum Aufbringen der Lötpaste 5 ist das Stencil-Druckverfahren, welches das Aufbringen besonders genauer Formen (die Toleranz beträgt ca. 30 µm) von Lötdepots mit konstanter Höhe ermöglicht.

Fig. 5a zeigt eine Draufsicht auf die Trägerplatte 1 der Fig. 4a nach dem Schmelzvorgang wobei ein auf der Trägerplatte 1 befindlicher loser Lötgutrückstand in Form einer Lötperle 9 erkennbar ist. Dieser Lötgutrückstand steht mit einer unvollständigen Lötverbindung in Zusammenhang (dritter Kontaktbereich 8), die in Fig. 5b erkennbar ist, in der eine Schnittdarstellung der Trägerplatte 1 entlang der Schnittlinie AA der Fig. 5a gezeigt ist. Die Bauteilkontaktflächen 11 des elektronischen Bauteils 10 befinden sich dabei oberhalb korrespondierender Trägerplattenkontaktflächen 2. Vergleicht man Fig. 4b mit Fig. 5b, so ist deutlich ersichtlich, dass das Volumen des an den Trägerplattenkontaktflächen befindlichen Lötgutes 15 geringer ist als das Volumen der Lötpaste 5 vor dem Schmelzvorgang. Dieser Unterschied ist teilweise durch Verdampfung von in der Lötpaste 5 enthaltenem Flussmittel verursacht. Eine weitere Ursache liegt im gezeigten Beispiel gemäß Fig. 5b darin, dass sich ein Teil des Lötgutes in Form einer Lötperle 9 von der Trägerplattenkontaktfläche 2 gelöst hat. Die Lötperle 9 hat sich in einem Bereich auf der Lötstopplackschicht 12 gebildet, welcher soweit von einer Kontaktfläche entfernt ist, dass in diesem Bereich befindliches Lötgut 15 nichtmehr der nächstgelegenen Kontaktfläche zufließt, sondern an der Lötstopplackschicht 12 befindliche, von den Kontaktflächen losgelöste Lötperlen 9 bildet. Solche Lötperlen 9 sind unerwünscht, da sie zum einen die Menge an Lötgut 15 an Kontaktstellen verringern und zum anderen eine Fehlerquelle darstellen, da diese Lötperlen 9 sich von der Lötstopplackschicht 12 lösen und Kurzschlüsse verursachen können. Zur Verdeutlichung der Problematik des Volumensverlusts der Lötpaste 5 während des Schmelz- und Abkühlvorganges sind drei beispielhafte Kontaktbereiche 6 bis 8 dargestellt, welche folgend kurz diskutiert werden.

Ein erster Kontaktbereich 6 zeigt eine nur teilweise verlötete Trägerplattenkontaktfläche 2 bzw. Bauteilkontaktfläche 11. Die elektrische Leitfähigkeit der Verbindung der Kontaktflächen ist darin zwar sichergestellt, allerdings ist der elektrische Widerstand aufgrund der Querschnittsverengung der Lötstelle erhöht sowie die thermische und mechanische Anbindung verschlechtert. Die Querschnittsverengung führt zu dem zu einer verringerten mechanischen Belastbarkeit der Lötverbindung. Ein zweiter Kontaktbereich 7 zeigt eine Lötstelle mit Lufteinschlüssen (Lunkern), die den effektiven Querschnitt der Lötverbindung reduzieren und deren Auswirkungen im Wesentlichen analog zu der Querschnittsminderung gemäß dem ersten Kontaktbereich 6 sind. Luft- oder Flussmitteleinschlüsse in Lötverbindungen sind besonders problematisch, da diese nur schwer erkennbar sind. Ein dritter Kontaktbereich 8 zeigt ein Szenario, in welchem sich das Lötgut 15 soweit von einer Bauteilkontaktfläche 11 zurückgezogen hat, sodass ein durchgängiger Spalt eine elektrische Verbindung mit der gegenüberliegenden Trägerplattenkontaktfläche 2 verhindert und sich ein Teil des fehlenden Lötguts 15 in Form der zuvor erwähnten Lötperle 9 auf der Lötstopplackschicht 12 befindet.

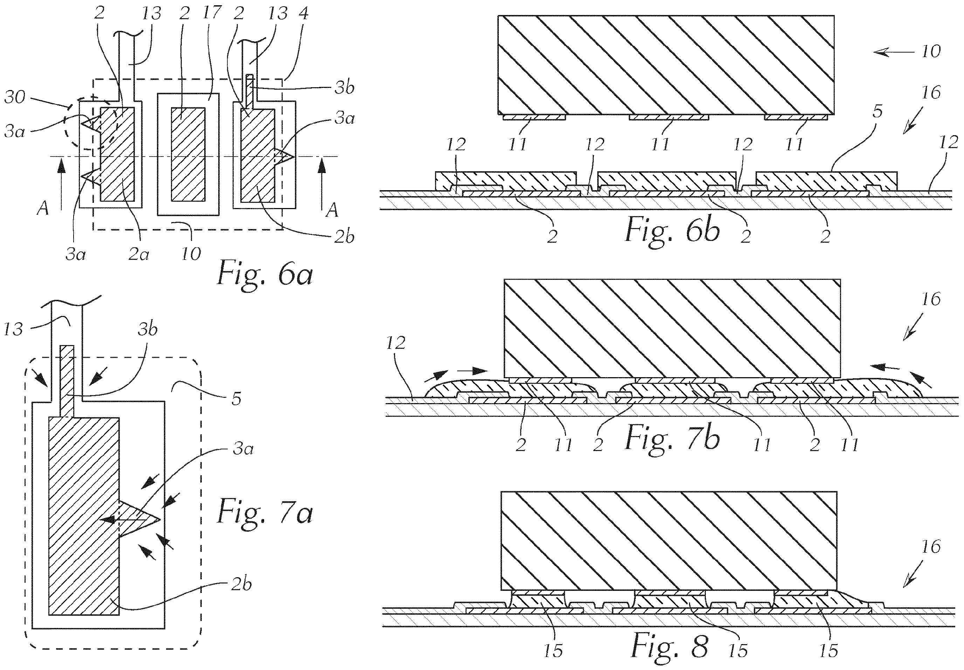

Fig. 6a zeigt eine Draufsicht auf ein System umfassend eine Trägerplatte 16 (siehe Fig. 6b) und zumindest einen an der Trägerplatte 16 montierten elektronischen Bauteil 10, wobei die Position des elektronischen Bauteils 10 mit einer strichlierten Linie angedeutet ist. Der Aufbau der Trägerplatte 16 stimmt in diesem gezeigten Beispiel mit jenem der Trägerplatte 1 des zuvor diskutierten Standes der Technik überein, mit Ausnahme von erfindungsgemäßen Aussparungen, die Hilfskontakte 3a und 3b bilden und im Folgenden noch näher beschrieben werden. So weist die Trägerplatte 16 Trägerplattenkontaktflächen 2 auf, wobei das elektronische Bauteil 10 dazu korrespondierende Bauteilkontaktflächen 11 (siehe Fig. 6b, 7b und 8) aufweist, wobei die Trägerplattenkontaktflächen 2 vollständig von dem elektronischen Bauteils 10 überdeckt und von einer Lötstopplackschicht 12 umgeben sind, die die Trägerplattenkontaktflächen 2 begrenzt, wobei in der Lötstopplackschicht 12 in diesem Beispiel vier kanalartige Aussparungen vorgesehen sind, die jeweils eine Hilfskontaktflächen 3a bzw. 3b ausbilden. Die Hilfskontaktflächen 3a bzw. 3b kontaktieren die Trägerplattenkontaktflächen 2, wobei zumindest die Trägerplattenkontaktflächen 2, die Bauteilkontaktflächen 11 und die Hilfskontaktflächen 3a bzw. 3b eine benetzbare Oberfläche aufweisen. Der Umfang der Trägerplattenkontaktflächen 2 wird im Allgemeinen durch die die Trägerplattenkontaktfläche 2 umgebende Lötstopplackschicht 12 begrenzt. In jenem Bereich, in welchem die Lötstopplackschicht 12 durch die Hilfskontaktfläche 3a bzw. 3b unterbrochen ist, kann die Hilfskontaktfläche 3a bzw. 3b von der Trägerplattenkontaktfläche 2 unterschieden werden, indem die die Kanten der Trägerplattenkontaktflächen 2, die hin zu der Hilfskontaktfläche 3a bzw. 3b führen, gedanklich verlängert werden. In den Figuren 6a, 7a und 9a ist dies durch eine strichlierte Linie angedeutet. Die Hilfskontaktfläche 3 kann daher durchaus einstückig mit der Trägerplattenkontaktfläche 2 ausgebildet sein und eine durchgängige Fläche ausbilden - dies ist sogar von Vorteil. Allerdings unterscheidet sich die Hilfskontaktfläche 3a bzw. 3b von der Trägerplattenkontaktfläche 2 darin, dass die Hilfskontaktfläche 3a bzw. 3b eine völlig andere Funktion erfüllt und nicht dazu eingerichtet ist, direkt mit einer Bauteilkontaktfläche 11 verbunden zu werden. Vielmehr dient die Hilfskontaktfläche 3a bzw. 3b, wie eingangs erwähnt, dem Zubringen von Lötgut 15 (siehe Fig. 8) zu einer in der Nähe der Hilfskontaktfläche 3a bzw. 3b befindlichen Lötverbindung. Zu diesem Zweck ist die Hilfskontaktfläche 3a bzw. 3b mit Hilfe einer kanalartigen Aussparung in der Lötstopplackschicht 12 ausgebildet, die vorzugsweise nicht von einer Bauteilkontaktfläche 11 überdeckt wird. Es ist dabei vorteilhaft, wenn die die Hilfskontaktfläche 3 die Trägerplattenkontaktfläche 2 entlang von maximal 5%, 10%, 15% oder 20% des Umfangs der Trägerplattenkontaktfläche 2 kontaktiert. Die Trägerplatte 16 weist drei Trägerplattenkontaktflächen 2 auf, wobei eine Trägerplattenkontaktfläche 2a über zwei Hilfskontaktflächen 3a verfügt, die als gleichschenkeliges Dreieck geformt sind. Eine weitere Trägerplattenkontaktfläche 2b weist ebenso zwei Hilfskontaktflächen 3a bzw. 3b auf, wobei die Hilfskontaktfläche 3b auf einer Zuleitung ausgebildet ist und rechteckig geformt ist. Sämtliche Kontaktflächen sind dabei vorzugsweise als verkupferte Flächen ausgebildet.

Fig. 6b zeigt eine Schnittdarstellung der Trägerplatte 16 entlang der Schnittlinie AA der Fig. 6a. Darin ist der elektronische Bauteil 10 dargestellt, der oberhalb der Trägerplatte 16 positioniert ist, um auf die Trägerplatte 16 aufgesetzt zu werden. Die Trägerplattenkontaktflächen 2a und 2b können nunmehr großzügig mit Lötpaste 5 überdruckt werden, da die Hilfskontaktflächen 3a und 3b die Bildung von losen Lötgutrückständen vorbeugen und für ausreichend Lötgut 15 (siehe Fig. 8) sorgen, um die durch das verdampfen von Flussmittel verursachte Volumensverringerung auszugleichen bzw. Bauteile mit höherem Lötmaterialbedarf mit genügend Lötgut 15 zu versorgen, ohne kostenintensive Stufenschablonen hierfür verwenden zu müssen. Als Bauteile mit zusätzlichem Lötgutbedarf seien beispielsweise Stecker, insbesondere elektrische Steckverbindungen erwähnt, die einen deutlichen höheren Lötgutbedarf wie beispielsweise QFP-Bauteile (quad flat package) aufweisen und bisher nur mittels speziell angepasster Stufenschablonen mit ausreichend Lötgut versorgt werden konnten. Die Erfindung ist besonders vorteilhaft mit der Fine-Pitch-Technologie kombinierbar, bei der die Abstände zwischen Kontaktflächen und/oder Pins besonders gering sind. Einerseits erlaubt die Erfindung eine exakte Vorgabe bzw. das Anbringen von zusätzlichem Lötgut 15 an einer Verbindung. Anderseits wird die Bildung von Lötperlen 9 vorgebeugt, die Kurzschlüsse dadurch ausgelöste Defekte verursachen können.

Fig. 7a zeigt eine Detailansicht einer Trägerplattenkontaktfläche 2 mitsamt einem die Trägerplattenkontaktflächen 2 umgebenden Bereich während eines Schmelzvorganges. Ein mit Lötpaste 5 bedruckter Bereich ist darin mit einer in sich geschlossenen strichlierten Linie angedeutet, wobei dieser bedruckte Bereich die Trägerplattenkontaktfläche 2b sowie die Hilfskontaktfläche 3a vollständig bedeckt. Wird die Lötpaste bei z.B. gemäß dem Reflow-Lötverfahren geschmolzen, so sammelt sich Lötgut auf den Kontakflächen, wobei das auf der Lotstopplackschicht aufgetragene Lötgut mit Hilfe der Hilfskontaktflächen 3a und 3b eingefangen wird. Die Flussrichtung des "eingefangenen" Lötgutes ist in Fig. 7a durch Pfeilsymbole dargestellt. Fig. 7a veranschaulicht den Schmelzvorgang an der Trägerplatte 16 in einer eine Seitenansicht der Trägerplatter 16 der Fig. 7a, wobei der elektronische Bauteil 10 bereits auf der Trägerplatte 16 positioniert ist.

Fig. 8 zeigt die Trägerplatte 16 gemäß Fig. 7a nach dem Schmelzvorgang. Darin ist das Lötgut 15 den Trägerplattenkontaktflächen 2 vollständig und rückstandslos zugeflossen, sodass die Bauteilkontaktflächen 11 vollständig mit den dazu korrespondierenden Trägerplattenkontaktflächen 2 verbunden sind. Die eingangs beschriebenen Nachteile des Standes der Technik können daher durch die Erfindung überwunden werden.

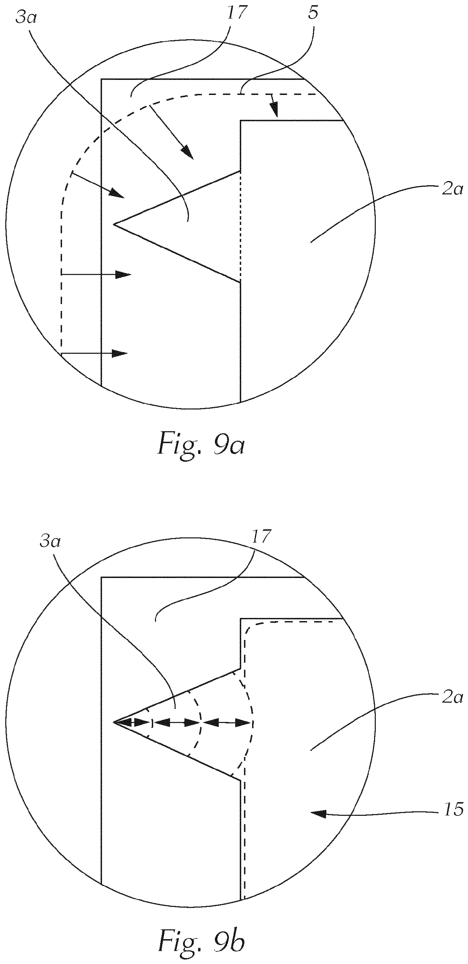

Fig. 9a zeigt eine Detailansicht einer der Hilfskontaktfläche 3a an der Trägerplattenkontaktfläche 2a während eines Schmelzvorganges, wobei das Zufließen der geschmolzenen Lötpaste 5 hin zu der Hilfskontaktfläche 3a und der Trägerplattenkontaktfläche 2a durch Pfeilsymbole verdeutlicht ist. Fig. 9b zeigt die Detailansicht der Fig. 9a nachdem sich bereits die gesamte Lötpaste 5 verflüssigt und an der Hilfskontaktfläche 3a und der Trägerplattenkontaktfläche 2a festgesetzt hat. Die Oberflächenspannung des geschmolzenen Lötgutes 15 führt dazu, dass die Menge des an der Hilfskontaktfläche 3 befindlichen Lötgutes 15 hin zu der Trägerplattenkontaktfläche 2a zunimmt. Dies ist in Fig. 9b durch Pfeilsymbole verdeutlicht, welche durch strichlierte, kreisbogenförmige Niveaulinien voneinander getrennt sind.

Natürlich können zwei oder mehrere elektronische Bauteile 10 an der Trägerplatte 16 angeordnet sein. Auch kann die Anzahl der Hilfskontaktflächen 3 individuell an die Anforderungen einzelner Bauteile angepasst werden. Zudem sind nach dem erfindungsgemäßen Verfahren Klebepunkte 4 (siehe Fig. 3a, 4a und 5a zum Stand der Technik) vorgesehen, mit Hilfe derer elektronische Bauteile 10 fixiert werden.

## Patentansprüche

1. Verfahren zum lötenden Verbinden zumindest eines elektronischen Bauteils (10) mit zumindest einer Trägerplatte (16), wobei die Trägerplatte (16) zumindest eine Trägerplattenkontaktfläche (2, 2a, 2b) und das elektronische Bauteil (10) zumindest eine dazu korrespondierende Bauteilkontaktfläche (11) aufweist, wobei die zumindest eine Trägerplattenkontaktfläche (2, 2a, 2b) zumindest von einer Lötstopplackschicht (12) umgeben ist, die die zumindest eine Trägerplattenkontaktfläche (2, 2a, 2b) begrenzt, wobei in der Lötstopplackschicht (12) zumindest eine kanalartige Aussparung vorgesehen ist, durch die zumindest eine Hilfskontaktfläche (3a, 3b) ausgebildet ist, welche die zumindest eine Trägerplattenkontaktfläche (2, 2a, 2b) kontaktiert, wobei zumindest die Trägerplattenkontaktfläche (2, 2a, 2b), die Bauteilkontaktfläche (11) und die Hilfskontaktfläche (3a, 3b) eine benetzbare Oberfläche aufweisen, umfassend die folgenden Schritte:
a) Aufbringen von Lötpaste (5) auf die zumindest eine Trägerplattenkontaktfläche (2, 2a, 2b) und über letztere hinaus, wobei die gesamte Hilfskontaktfläche (3a, 3b) mit Lötpaste (5) bedeckt wird sowie Lötpaste (5) über die Hilfskontaktfläche (3a, 3b) hinaus aufgebracht wird, wobei die über die Hilfskontaktfläche (3a, 3b) hinaus gehende mit Lötpaste (5) bedeckte Fläche einen Flächeninhalt von zumindest 100%, besonders bevorzugt zumindest 200% des Flächeninhaltes der Hilfskontaktfläche (3a, 3b) aufweist,
b) Bestücken der Trägerplatte (2, 2a, 2b) mit dem zumindest einen elektronischen Bauteil (10), wobei die Bauteilkontaktfläche (11) die dazu korrespondierende Trägerplattenkontaktfläche (2, 2a, 2b) zumindest teilweise überdeckt und die Hilfskontaktfläche (3) über den so überdeckten Bereich hinaus ragt, die Trägerplattenkontaktfläche (2, 2a, 2b) vollständig von dem elektronischen Bauteil (10) überdeckt wird,
c) Erhitzen des Lötmaterials (13) zum Herstellen einer gelöteten Verbindung zwischen der Trägerplatte (16) und dem zumindest einen elektronischen Bauteil (10), **dadurch gekennzeichnet, dass** in oder nach dem Schritt b) das zumindest eine elektronische Bauteil (10) zusätzlich mittels Klebepunkten (4) an zumindest einer Ecke des elektronischen Bauteils (10) an der Trägerplatte (16) fixiert wird, wobei die Härtetemperatur der Klebepunkte (4) unterhalb der Schmelztemperatur einer auf die Trägerplattenkontaktfläche aufgebrachten Lötpaste (5) ist, wobei das elektronische Bauteil (10) ein QFN-Gehäuse aufweist.

2. Verfahren nach Anspruch 1, **dadurch gekennzeichnet, dass** die in Schritt a) auf die zumindest eine Trägerplattenkontaktfläche (2, 2a, 2b) aufgebrachte Lötpaste (5) eine Fläche der Größe von zumindest 120%, vorzugsweise zumindest 150% des Flächeninhalts der Trägerplattenkontaktfläche (2, 2a, 2b) bedeckt.

## Claims

1. Method for solder connecting at least one electronic component (10) to at least one carrier plate (16), the carrier plate (16) having at least one carrier plate contact face (2, 2a, 2b) and the electronic component (10) having at least one component contact face (11) corresponding thereto, the at least one carrier plate contact face (2, 2a, 2b) being surrounded by at least one solder resist layer (12) which delimits the at least one carrier plate contact face (2, 2a, 2b), wherein in the solder resist layer (12) at least one channel-like recess is provided, having at least one auxiliary contact face (3a, 3b) formed therethrough, which contacts the at least one carrier plate contact face (2, 2a, 2b), wherein at least the carrier plate contact face (2, 2a, 2b), the component contact face (11) and the auxiliary contact face (3a, 3b) have wettable surfaces, the method comprising the following steps:
a) applying solder paste (5) to the at least one carrier plate contact face (2, 2a, 2b) and beyond the latter, wherein the entire auxiliary contact face (3a, 3b) is covered with solder paste (5) and solder paste (5) is applied beyond the auxiliary contact face (3a, 3b), wherein the area that is covered with solder paste (5) beyond the auxiliary contact face (3a, 3b) has an area of at least 100%, more preferably at least 200%, of the area of the auxiliary contact face (3a, 3b),
b) equipping the carrier plate (2, 2a, 2b) with the at least one electronic component (10), the component contact face (11) at least partially covering the carrier plate contact face (2, 2a, 2b) corresponding thereto, and the auxiliary contact face (3) extending beyond the region thus covered, the carrier plate contact face (2, 2a, 2b) being completely covered by the electronic component (10),
c) heating the solder material (13) so as to produce a solder connection between the carrier plate (16) and the at least one electronic component (10),
**characterized in that** during or after step b) the at least one electronic component (10) is additionally fixed to the carrier plate (16) by means of adhesive dots (4) on at least one corner of the electronic component (10), wherein the hardening temperature of the adhesive dots (4) is below the melting temperature of a solder paste (5) applied to the carrier plate contact face, wherein the electronic component (10) comprises a QFN housing.

2. Method according to claim 1, **characterized in that** the solder paste (5) applied in step a) to the at least one carrier plate contact face (2, 2a, 2b) covers an area having an amount of at least 120%, preferably at least 150%, of the area of the carrier plate contact face (2, 2a, 2b).

## Revendications

1. Procédé pour connecter en brasant au moins un composant électronique (10) sur au moins une plaque de support (16), la plaque de support (16) présentant au moins une surface de contact de plaque de support (2, 2a, 2b) et le composant électronique (10) présentant au moins une surface de contact de composant (11) correspondant à celle de la plaque de support, ladite au moins une surface de contact de plaque de support (2, 2a, 2b) étant entourée au moins d'une couche de réserve de soudure (12) qui délimite ladite au moins une surface de contact de plaque de support (2, 2a, 2b), au moins un évidement en forme de canal étant prévu dans la couche de réserve de soudure (12), à travers lequel est formée au moins une surface de contact auxiliaire (3a, 3b) qui est en contact avec ladite au moins une surface de contact de plaque de support (2, 2a, 2b), au moins la surface de contact de plaque de support (2, 2a, 2b), la surface de contact de composant (11) et la surface de contact auxiliaire (3a, 3b) comportant une surface mouillable, le procédé comprenant les étapes suivantes :
a) appliquer de la pâte à braser (5) sur et au-delà de ladite au moins une surface de contact de plaque de support (2, 2a, 2b), la surface de contact auxiliaire (3a, 3b) entière étant recouverte de pâte à braser (5) et la pâte à braser (5) étant appliquée au-delà de la surface de contact auxiliaire (3a, 3b), la surface que est couverte de pâte à souder (5) au-delà de la surface de contact auxiliaire (3a, 3b) ayant une ampleur d'au moins 100%, plus préféré d'au moins 200%, de la surface de la surface de contact auxiliaire (3a, 3b),
b) équiper la plaque de support (2, 2a, 2b) d'au moins un composant électronique (10), la surface de contact de composant (11) recouvrant au moins partiellement la surface de contact de plaque de support (2, 2a, 2b) qui lui correspond et la surface de contact auxiliaire (3) s'étendant au-delà de la zone ainsi recouverte, la surface de contact de plaque de support (2, 2a, 2b) étant entièrement recouverte par le composant électronique (10),
c) chauffer le matériau de soudage (13) pour réaliser une liaison soudée entre la plaque de support (16) et ledit au moins un composant électronique (10),
**caractérisé en ce que**, dans ou après l'étape b), ledit au moins un composant électronique (10) est en outre fixé sur la plaque de support (16) au moyen de points de colle (4) sur au moins un coin du composant électronique (10), la température de durcissement des points adhésifs (4) étant inférieure à la température de fusion d'une pâte à souder (5) appliquée sur la surface de contact de plaque de support, le composant électronique (10) ayant un boîtier QFN.

2. Procédé selon la revendication 1, **caractérisé en ce que** la pâte à braser (5) appliquée dans l'étape a) sur ladite au moins une surface de contact de plaque de support (2, 2a, 2b) couvre une surface ayant une ampleur d'au moins 120 %, de préférence au moins 150 %, de l'ampleur de la surface de contact de plaque de support (2, 2a, 2b).
